# EUROPEAN PATENT APPLICATION

(11) **EP 3 581 804 A1**
(43) Date of publication of application: **18.12.2019**
(21) Application number: 18750880.9
(22) Date of filing: 07.02.2018
(51) Int. Cl.: F04D 29/64, F04D 29/52

(54) **FAN UNIT**

(30) Priority: 13.02.2017 JP 2017024095
(71) Applicant: Nidec Servo Corporation, Kiryu-shi, Gunma 376-0011 (JP)
(72) Inventor: SHIMAMOTO, Masakazu, Kiryu-shi Gunma 376-0011 (JP)
(74) Representative: Stöckeler, Ferdinand
(86) International application number: PCT/JP2018/004224
(87) International publication number: WO 2018/147330

(57) **Abstract**

One aspect of a fan unit of the present invention includes: a fan main body including a blade part that rotates and a frame that rotatably supports the blade part; and a casing including a main body provided with a housing recess in which the fan main body is to be housed, and a snap-fit portion for fixing the frame in the housing recess. The housing recess includes a housing bottom having a surface facing upward and a housing inner circumferential portion extending upward from the housing bottom, and opens upward. The snap-fit portion includes an elastic portion extending upward along the housing inner circumferential portion, and a claw portion projecting horizontally from a tip end portion of the elastic portion. A lower surface of the claw portion is inclined upward toward the tip of the claw portion. The frame is interposed between the lower surface of the claw portion and the housing bottom in a state of being in contact with the lower surface of the claw portion and the housing bottom.

## Description

### TECHNICAL FIELD

The present invention relates to a fan unit.

### BACKGROUND ART

A heat dissipation device (fan main body) may be attached to an electric device to dissipate heat generated internally to the outside. As a fixing structure of such a heat dissipation device, one employing screw fixing is known (Patent Literature 1).

### CITATIONS LIST

### PATENT LITERATURE

Patent Literature 1: JP 2000-209717 A

### SUMMARY OF INVENTION

### TECHNICAL PROBLEMS

It is conceivable to reduce costs by adopting a snap fit as a fixing structure of a heat dissipation device. However, in general, a fixing structure using a snap fit has a problem that it is easily loosened and rattled.

In view of such a problem, one aspect of the present invention aims to provide a fan unit employing a fixing structure that reduces costs and suppresses loosening and rattling.

### SOLUTION TO PROBLEMS

One aspect of a fan unit of the present invention includes: a fan main body including a blade part that rotates and a frame that rotatably supports the blade part; and a casing including a main body provided with a housing recess in which the fan main body is to be housed, and a snap-fit portion for fixing the frame in the housing recess. The housing recess includes a housing bottom having a surface facing upward and a housing inner circumferential portion extending upward from the housing bottom, and opens upward. The snap-fit portion includes an elastic portion extending upward along the housing inner circumferential portion, and a claw portion projecting horizontally from a tip end portion of the elastic portion. A lower surface of the claw portion is inclined upward toward the tip of the claw portion. The frame is interposed between the lower surface of the claw portion and the housing bottom in a state of being in contact with them.

### ADVANTAGEOUS EFFECTS OF INVENTION

According to one aspect of the present invention, it is possible to provide a fan unit employing a fixing structure that reduces costs and suppresses loosening and rattling.

### BRIEF DESCRIPTION OF DRAWINGS

FIG. 1 is a perspective view of a fan unit of one embodiment.
FIG. 2 is a plan view of a fan unit of one embodiment.
FIG. 3 is a cross-sectional view taken along line III-III of FIG. 2.
FIG. 4 is a plan view of a casing of one embodiment.
FIG. 5 is a partial cross-sectional view taken along line V-V of FIG 4.
FIG. 6 is a cross-sectional view for explaining a process of housing a fan main body of one embodiment in a housing recess.
FIG. 7 is a perspective view of a positioning pin provided to a housing bottom of one embodiment.
FIG. 8 is a cross-sectional view of a positioning hole inserted in a positioning hole of one embodiment.

### DESCRIPTION OF EMBODIMENT

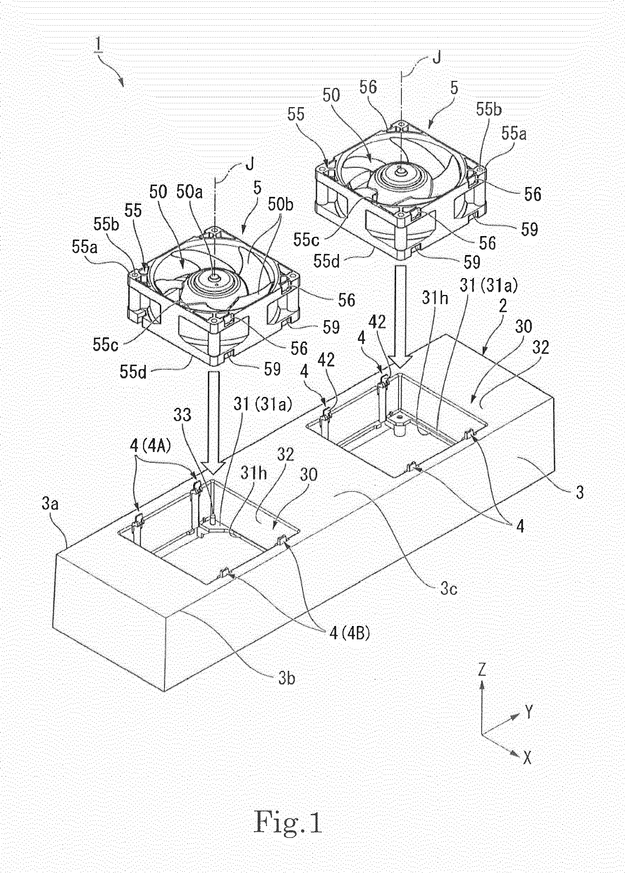

Hereinafter, a fan unit 1 according to an embodiment of the present invention will be described with reference to the accompanying drawings. In the accompanying drawings, an xyz coordinate system is shown appropriately as a three-dimensional orthogonal coordinate system. In the xyz coordinate system, a z-axis direction is assumed to be a direction parallel to a central axis J of a fan main body 5. A y-axis direction is assumed to be a direction orthogonal to the z-axis direction, extending from the upper right to the lower left in FIG. 1. An x-axis direction is assumed to be a direction orthogonal to both the y-axis direction and the z-axis direction.

In the following description, the positive side (+z side, one side) in the z-axis direction is referred to as an "upper side", and the negative side (-z side, the other side) in the z-axis direction is referred to as a "lower side". It should be noted that the definitions of the upper side and the lower side are made simply for the sake of description, and are not meant to restrict actual relative positions or directions. Also, unless otherwise explained, a direction (z-axis direction) parallel to the central axis J is simply referred to as an "axial direction" or a "vertical direction", a radial direction having its center on the central axis J is simply referred to as a "radial direction", and a circumferential direction having its center on the central axis J, that is, a direction about the central axis J, is simply referred to as a "circumferential direction".

### <Fan unit>

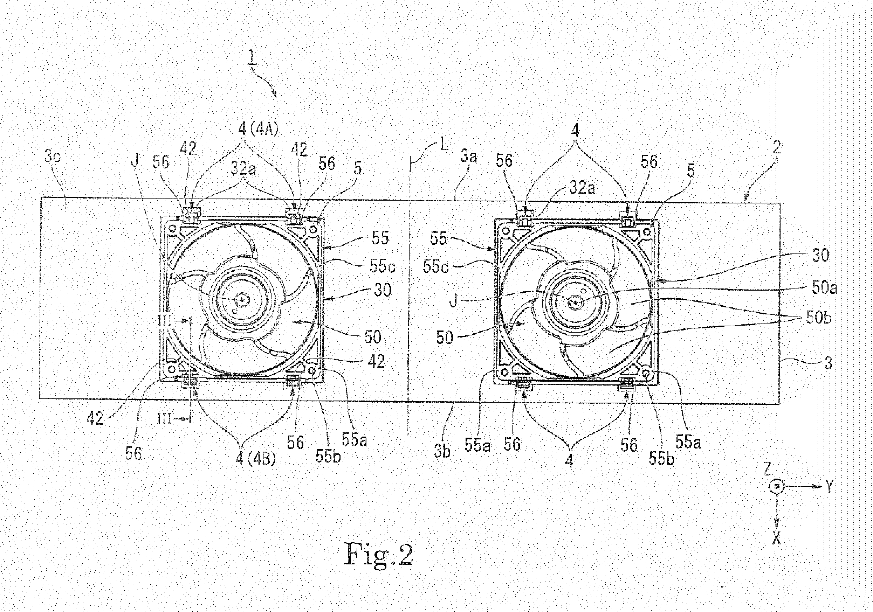

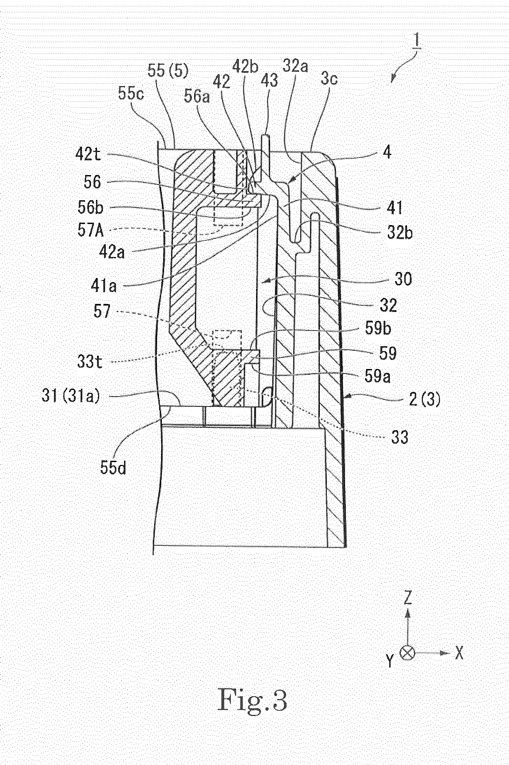

FIG. 1 is a perspective view of a fan unit 1 of the present embodiment. FIG. 2 is a plan view of the fan unit 1. FIG. 3 is a cross-sectional view taken along line III-III of FIG. 2. The fan unit 1 includes two fan main bodies 5 and a casing 2 that houses the two fan main bodies 5. The casing 2 is provided with housing recesses 30 opened to the upper side. The fan main body 5 is inserted into the housing recess 30 of the casing 2 from the upper side, and is housed in the housing recess 30.

### [Fan main body]

The fan main body 5 has an impeller (blade part) 50 that rotates around a central axis J extending in the vertical direction, a motor (not shown) that causes the impeller 50 to rotate, and a frame 55 that supports the impeller 50 and the motor.

The impeller 50 has a cylindrical impeller cup 50a connected to the rotation shaft of the motor along the central axis J, and a plurality of wings 50b arranged along the circumferential direction from the outer peripheral surface of the impeller cup 50a. The impeller 50 rotates in a counterclockwise direction as viewed from above, for example. The motor is disposed inside the impeller 50.

The frame 55 is in a form of a rectangular tube extending in the vertical direction. The outer shape of the frame 55 is substantially square when viewed from the vertical direction. The frame 55 circumferentially surrounds the impeller 50 and the motor from the radially outer side. The frame 55 rotatably supports the impeller 50. The frame 55 also supports the motor from below. The frame 55 has corner portions 55a arranged at the four corners. The corner portion 55a is substantially triangular when viewed from the vertical direction. The corner portion 55a has a through hole 55b. A screw for fixing the frame 55 to the casing 2 can be inserted into the through hole 55b. Such a screw is used as a backup for a snap fit fixing structure described later. That is, the frame 55 can be fixed to the casing 2 with a screw inserted into the through hole 55b and fastened to the casing 2, even if the fixing structure by the snap fit is damaged for any reason.

The frame 55 has an upper surface 55c facing upward and a lower surface 55d facing downward. The upper surface 55c and the lower surface 55d are provided with openings at least in a portion overlapping with the impeller 50 when viewed from the vertical direction, so that the air flow accompanying the rotation of the impeller 50 is not hindered.

As viewed from the upper side, the edge of the frame 55 is provided with four upper holding portions (first holding portions) 56. The upper holding portion 56 is in the form of a plate substantially parallel to the upper surface 55c. The upper holding portion 56 is located below the upper surface 55c. The upper holding portion 56 is recessed downward with respect to the upper surface 55c. As shown in FIG. 3, the upper holding portion 56 includes a first holding upper surface (upper surface) 56a facing upward, and a first holding lower surface (lower surface) 56b located on the opposite side of the first holding upper surface 56a. The four upper holding portions 56 are respectively provided in pairs on two opposing sides of the four sides of the frame 55, when viewed from above. A space is provided above the upper holding portion 56. In the space above the upper holding portion 56, a claw portion 42 of the casing 2, described below, is housed.

As viewed from below, the edge of the frame 55 is provided with four lower holding portions (second holding portions) 59 having the same configuration as that of the upper holding portion 56. The lower holding portion 59 is located above the lower surface 55d and below the upper holding portion 56. The lower holding portion 59 is recessed upward with respect to the lower surface 55d. The lower holding portion 59 has a shape in which the upper holding portion 56 is vertically inverted. The lower holding portion 59 overlaps with the upper holding portion 56 as viewed from the vertical direction. The lower holding portion 59 includes a second holding upper surface (upper surface) 59a facing upward when the fan main body 5 is inverted, and a second holding lower surface (inversion lower surface) 59b located opposite to the second holding upper surface 59a. In FIG. 3, the second holding upper surface 59a faces downward, and the second holding lower surface 59b faces upward.

According to the present embodiment, the fan main body 5 has the upper holding portion 56 and the lower holding portion 59 which are disposed at different positions in the vertical direction and overlap with each other when viewed from the vertical direction. In the upper holding portion 56 and the lower holding portion 59, claw portions are hooked to either the upper holding portion 56 or the lower holding portion 59 when the fan main body 5 is inverted. As a result, the fan main body 5 can be housed in the housing recess 30 in an inverted manner, and the air blowing direction to the casing 2 can be easily changed.

As shown in FIG. 3, the lower surface 55d of the frame 55 contacts the housing bottom 31 in a state where the fan main body 5 is housed in the housing recess 30. The lower surface 55d has a positioning hole 57 into which a positioning pin 33 provided to the housing bottom 31 is inserted. Similarly, the upper surface 55c of the frame 55 has a positioning hole 57A. In the positioning hole 57A, the positioning pin 33 is inserted when the fan main body 5 is inverted and housed in the housing recess 30.

### [Casing]

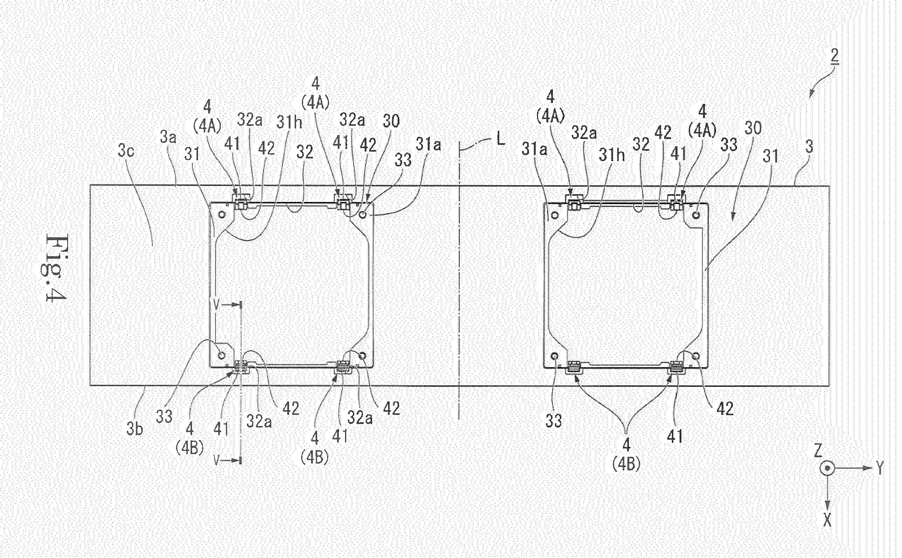

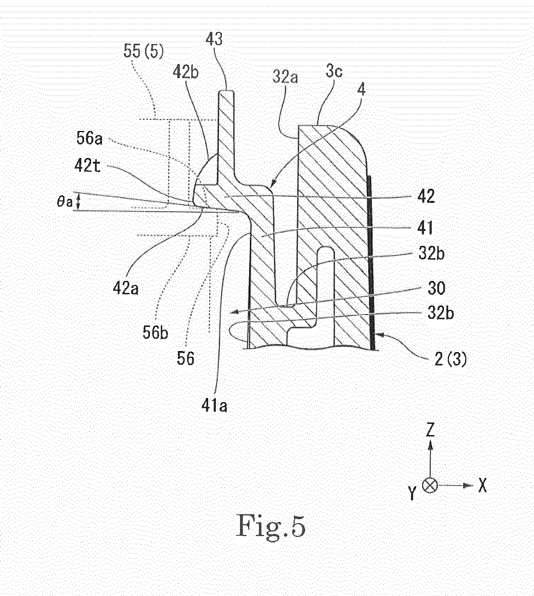

FIG. 4 is a plan view of the casing 2. FIG. 5 is a cross-sectional view taken along line V-V of FIG. 4. As shown in FIG. 4, the casing 2 has a main body 3 provided with two housing recesses 30, and snap-fit portions 4 provided four for each housing recess 30. The housing recess 30 houses the fan main body 5 therein. The snap-fit portion 4 fixes the frame 55 of the fan main body 5 in each of the housing recesses 30.

### [Main body 3]

The main body 3 has a rectangular shape in a plan view in which one direction (in the present embodiment, the y-axis direction) has long sides 3a and 3b when viewed from the vertical direction. The main body 3 has a symmetrical shape with respect to a center line L passing through the center of the pair of long sides 3a and 3b when viewed from the vertical direction. The main body 3 has an upper surface 3c facing upward.

The housing recess 30 is recessed downward from the upper surface 3c of the main body 3 and opens to the upper side. The two housing recesses 30 are provided side by side in the direction in which the long sides 3a and 3b of the main body 3 extend. The housing recess 30 has a substantially square shape as viewed from above. The housing recess 30 has a housing bottom 31 having a bottom surface (a surface facing upward) 31a, and a housing inner circumferential portion 32 extending upward from the housing bottom 31.

The housing bottom 31 is substantially square when viewed from above. The housing bottom 31 has an opening 31h penetrating in the vertical direction. The opening 31h of the housing bottom 31 overlaps with at least the impeller 50 of the fan main body 5 when viewed from the vertical direction, and does not inhibit the air flow accompanying the rotation of the impeller 50.

The bottom surface 31a of the housing bottom 31 is provided with positioning pins 33 for positioning the fan main body 5 in the housing bottom 31. The positioning pin 33 extends upward from the housing bottom 31. The positioning pin 33 is to be inserted into a positioning hole 57 provided in the frame 55.

The housing inner circumferential portion 32 surrounds the housing recess 30 from the radially outer side (horizontal direction). The housing inner circumferential portion 32 extends upward in an angular tube shape from the outer edge of the bottom surface 31a. As shown in FIG. 4, the housing inner circumferential portion 32 is provided with four recesses 32a that open to the upper side and to the inner side of the housing recess 30. Two of the four recesses 32a, provided to one housing recess 30, are provided along one long side 3b of the main body 3, and the other two are provided along the other long side 3b. As shown in FIG. 3, the recess 32a extends downward from the upper surface 3c of the main body 3 up to the middle of the depth direction (vertical direction) of the housing recess 30. The recess 32a has a recessed bottom surface 32b facing upward. The recessed bottom surface 32b is located between the bottom surface 31a of the housing recess 30 and the upper surface 3c of the main body 3 in the vertical direction.

### [Snap-fit portion]

As shown in FIG. 5, the snap-fit portion 4 includes an elastic portion 41 extending upward along the housing inner circumferential portion 32, a claw portion 42 projecting horizontally from the tip of the upper side the elastic portion 41 toward the inner side of the housing recess 30, and a grip portion 43 positioned above the claw portion 42 and projecting upward.

The elastic portion 41 extends upward from the recessed bottom surface 32b of the recess 32a. As shown in FIG. 4, the elastic portion 41 has a rectangular shape having a long side in a direction in which the long sides 3a and 3b of the main body 3 extend, when viewed from the vertical direction. The elastic portion 41 is easily bent in a direction (X-axis direction) orthogonal to the extending direction of the long sides 3a and 3b of the main body 3. As shown in FIG. 5, the elastic portion 41 has a front surface 41a facing the inside of the housing recess 30. The elastic portion 41 is elastically deformed in a state where the fan main body 5 is housed in the housing recess 30, and applies a stress of pressing the claw portion 42 to the first holding upper surface 56a of the fan main body 5.

The claw portion 42 is located at an upper end portion of the elastic portion 41. The claw portion 42 has a tip 42t located inside the housing recess 30. The claw portion 42 protrudes from the front surface 41a of the elastic portion 41 toward the tip 42t. The claw portion 42 also has a claw upper surface (upper surface) 42b facing upward and a claw lower surface (lower surface) 42a located on the opposite side thereof and facing downward.

In the process of housing the fan main body 5 in the housing recess 30, when the fan main body 5 is moved downward toward the housing recess 30, the first holding lower surface 56b of the fan main body 5 slides on the claw upper surface 42b, and the elastic portion 41 bends and the claw portion 42 moves to the outside of the housing recess 30. Furthermore, at the stage when the first holding upper surface 56a reaches below the claw lower surface 42a, the claw portion 42 moves to the inside of the housing recess 30, and the claw portion 42 is caught by the upper holding portion 56.

The claw lower surface 42a faces the bottom surface 31a of the housing bottom 31 in a state where the fan main body 5 is not housed in the housing recess 30. The claw lower surface 42a inclines upward toward the tip 42t of the claw portion 42. As shown in FIG. 3, the claw lower surface 42a contacts the first holding upper surface 56a of the upper holding portion 56 of the frame 55 of the fan main body 5.

In the conventional snap-fit structure, when the dimensions of the object to be fixed by the snap-fit structure vary and become smaller, a gap is generated between the parts engaged with each other. Therefore, the object fixed by the snap fit structure may rattle by the amount of the gap generated.

On the other hand, in the present embodiment, the distance from the base end in the projecting direction of the claw lower surface 42a to the bottom surface 31a is smaller than the distance along the vertical direction between the first holding upper surface 56a and the lower surface 55d of the frame 55. Meanwhile, the distance along the vertical direction from the tip in the projecting direction of the claw the lower surface 42a to the bottom surface 31a is larger than the distance along the vertical direction between the first holding upper surface 56a and the lower surface 55d of the frame 55. In the claw portion 42, the claw lower surface 42a is inclined as described above. Since the claw lower surface 42a of the claw portion is pressed to the inside of the housing recess 30 by the elasticity of the elastic portion 41, even if the dimensions along the vertical direction of the first holding upper surface 56a and the lower surface 55d of the frame 55 vary, the claw lower surface 42a contacts the first holding upper surface 56a at somewhere in the projecting direction. Thus, the frame 55 can be vertically interposed between the claw lower surface 42a and the bottom surface 31a, and a stress due to the elasticity of the elastic portion 41 can be applied. The frame 55 is interposed in a state of being in contact with the claw lower surface 42a and the housing bottom 31, and rattling of the frame 55 is suppressed.

As shown in FIG. 4, four snap-fit portions 4 are provided to each of the housing recesses 30. Since the casing 2 of the present embodiment is provided with two housing recesses 30, the casing 2 has a total of eight snap-fit portions 4. The four snap-fit portions 4 provided to one housing recess are classified into two first snap-fit portions 4A disposed along one long side 3a of the main body 3 and two second snap-fit portions 4B arranged along the other long side 3b. The first snap-fit portions 4A and the second snap-fit portions 4B are paired. The pair of first and second snap-fit portions 4A and 4B oppose each other along a direction (X-axis direction) orthogonal to the direction in which the long sides 3a and 3b of the main body 3 extend. The claw portions 42 of the pair of snap-fit portions (first and second snap-fit portions 4A and 4B) face each other. Since the claw lower surface 42a inclines upward toward the opposed claw portion 42, stresses in the opposite direction are applied to the fan main body 5 from the claw lower surfaces 42a of the pair of claw portions 42. That is, the claw portions 42 of the pair of snap-fit portions 4A and 4B press the frame 55 to the opposite side, whereby loosening and rattling of the frame 55 can be suppressed.

According to the present embodiment, it is possible to suppress loosening and rattling of the fan main body 5 housed in the housing recess 30, without using a fastening structure such as a screw. As a result, the number of components can be reduced, the assembly process can be simplified, and cost reduction can be realized.

In the snap-fit portion 4, the pair of claw portions 42 may not necessarily be disposed to face each other. As an example, the snap-fit portion 4 may be disposed only on one long side 3a of the pair of long sides 3a and 3b. In that case, the snap-fit portion 4 generates a stress that presses the fan main body 5 against the housing inner circumferential portion 32 on the other long side 3b of the housing recess 30, thereby suppressing rattling of the fan main body 5.

The inclination angle θa (see FIG. 5) of the claw lower surface 42a with respect to the horizontal plane is preferably larger than 0° and smaller than 45°, and more preferably, 3° or larger and 9° or smaller. By setting the inclination angle θa to be larger than 0°, the claw portion 42 can press the frame 55 against the inside of the housing recess 30 to achieve the above-described effect. Further, by setting the inclination angle to be 3° or larger, the stress that the claw portion 42 presses the frame 55 against the inside of the housing recess 30 can be sufficiently increased, and loosening and rattling of the frame 55 can be suppressed more effectively. By setting the inclination angle θa to be smaller than 45°, even in the case where an upward stress is caused in the fan main body 5 in a state where the fan main body 5 is housed in the housing recess 30, it is possible to suppress sliding between the claw lower surface 42a and the first holding upper surface 56a, and to suppress detachment of the fan main body 5 from the housing recess 30. Further, by setting the inclination angle θa to be 9° or smaller, detachment of the fan main body 5 can be suppressed more effectively.

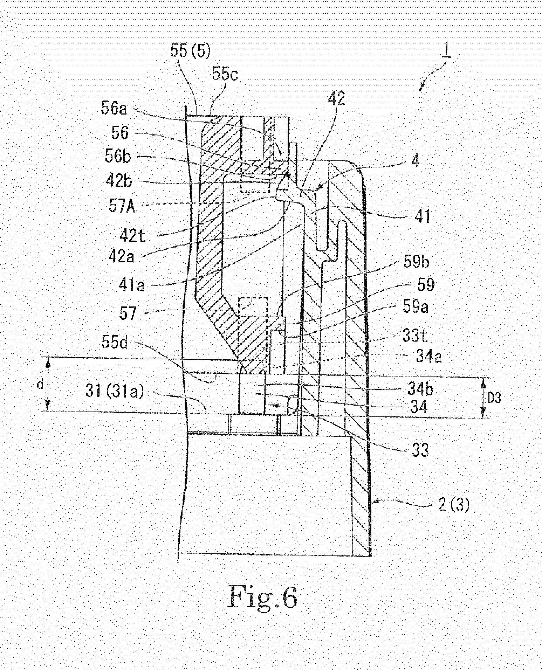

The claw upper surface 42b is inclined downward toward the tip 42t of the claw portion 42. FIG. 6 is a cross-sectional view for explaining the process of moving the fan main body 5 downward and housing it in the housing recess 30. In the process of housing the fan main body 5 in the housing recess 30, the first holding lower surface 56b of the fan main body 5 slides on the claw upper surface 42b. Since the claw upper surface 42b is inclined downward toward the tip of the claw portion 42, the elastic portion 41 is elastically deformed outward by the stress for moving the fan main body 5 downward, whereby the claw portion 42 can be moved to the outside of the housing recess 30. As a result, the distance between the claw portions 42 of the pair of snap-fit portions 4A and 4B is made wider than the width of the fan main body 5, and the fan main body 5 can be housed in the housing recess 30.

The claw upper surface 42b is curved in a circular arc, and the inclination with respect to the projecting direction (-x direction in FIG. 5) of the claw portion 42 increases toward the tip 42t of the claw portion 42. That is, the claw upper surface 42b is inclined downward while the inclination with respect to the projecting direction of the claw portion 42 is increased toward the tip 42t of the claw portion 42.

The inclination angle of the claw upper surface 42b with respect to the projecting direction of the claw portion 42 is referred to as an upper surface inclination angle. When the upper surface inclination angle approaches 90°, the ratio of the component force in the lateral direction, of the force exerted from the first holding lower surface 56b to the claw upper surface 42b, increases in the housing process of the fan main body 5. Accordingly, the elastic portion 41 can be elastically deformed with a small force. Therefore, although the fan main body 5 can be housed in the housing recess 30 with a small force, the dimension along the vertical direction of the claw portion 42 is increased.

In the present embodiment, the claw upper surface 42b is curved and the inclination of the claw upper surface 42b with respect to the projecting direction of the claw portion 42 is increased and gradually approached to 90° toward the tip 42t. As a result, the housing operation of the fan main body 5 can be facilitated, and the dimension of the claw portion 42 in the vertical direction can be sufficiently reduced. In addition, according to the present embodiment, since the claw upper surface 42b has the above-described configuration, even when the posture of the claw portion 42 is inclined to the outside of the housing recess 30 due to the elastic deformation of the elastic portion 41, the inclination angle of the claw upper surface 42b is secured to enable smooth housing operation.

The grip portion 43 protrudes upward from the claw portion 42. By gripping the grip portion 43, the operator can elastically deform the elastic portion 41 so as to move the claw portion 42 toward the outside of the housing recess 30. As a result, the operator can release the engagement of the claw portion 42 with the upper holding portion 56 and take out the fan main body 5 from the housing recess 30.

### [Positioning pin and positioning hole]

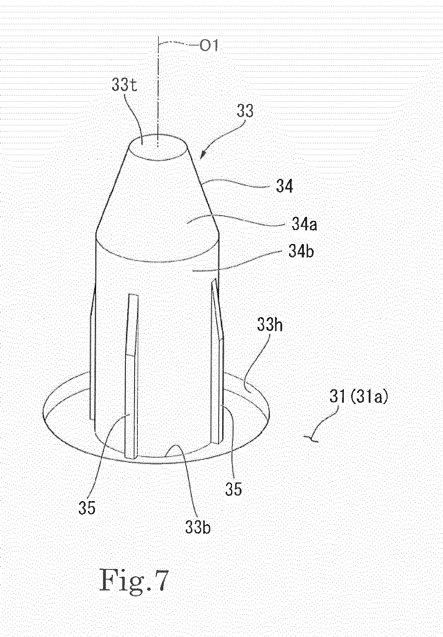

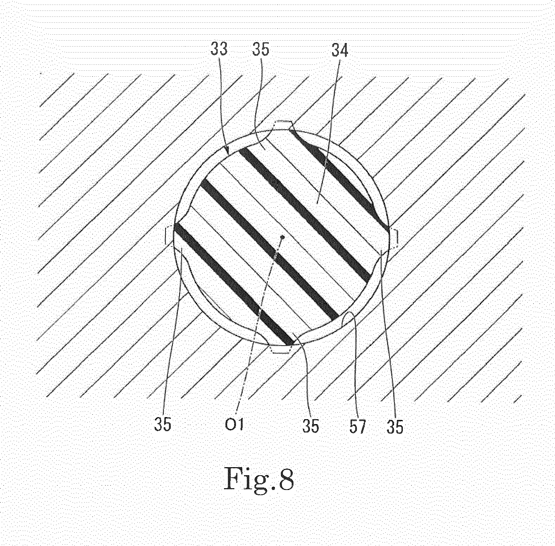

FIG. 7 is a perspective view of the positioning pin 33 provided to the housing bottom 31. FIG. 8 is a cross-sectional view of the positioning hole 57 inserted in the positioning hole 57.

As shown in FIG. 7, the positioning pin 33 protrudes upward from the bottom surface 31a of the housing bottom 31. The positioning pin 33 is located inside the recess 33h formed on the bottom surface 31a of the housing bottom 31. The recess 33h is recessed downward. The outer shape of the recess 33h in the plan view is circular. When viewed from the vertical direction, the positioning pin 33 and the recess 33h have concentric circular shapes.

The positioning pin 33 has a pin main body 34 extending in the vertical direction along an axis O1 parallel to the vertical direction, and a plurality of ribs 35 provided to the outer peripheral surface of the pin main body 34.

The pin main body 34 has a cylindrical portion 34b and a tapered portion 34a. That is, the positioning pin 33 has the cylindrical portion 34b and the tapered portion 34a. The cylindrical portion 34b extends along the axis O1 about the axis O1. The diameter of the cylindrical portion 34b is uniform. The tapered portion 34a is located above the cylindrical portion 34b. In the tapered portion 34a, the diameter of the positioning pin 33 decreases, from base end 33b side of the positioning pin 33 toward the tip 34t. Since the tapered portion 34a is provided, it facilitates insertion of the positioning pin 33 into the positioning hole 57. That is, the operator can insert the positioning pin 33 into the positioning hole 57 along the tapered portion 34a only by moving the fan main body 5 downward toward the housing bottom 31. Thereby, positioning can be realized easily.

As shown in FIG. 6, in the process of housing the fan main body 5 in the housing recess 30, the first holding lower surface 56b contacts the claw upper surface 42b. Thus, in a state where the first holding lower surface 56b and the claw upper surface 42b are in contact with each other, a distance D3 between the lower end of the positioning hole 57 and the housing bottom 31 is smaller than a height d of the positioning pin 33. Therefore, the positioning pin 33 is inserted into the positioning hole 57 before the first holding lower surface 56b and the claw upper surface 42b contact each other in the process of moving the fan main body 5 downward and housing it in the housing recess 30. The positioning pin 33 can be inserted into the positioning hole 57 before pressing the fan main body 5 downward to elastically deform the elastic portion 41 of the snap-fit portion 4. The operator does not have to align the positioning pin 33 with the positioning hole 57 while pressing the fan main body 5 downward. Here, the positional relationship in the vertical direction between the upper holding portion 56, the positioning hole 57, and the positioning pin 33 has been described. Such a relationship is also applied to the relationship between the lower holding portion 59, the positioning hole 57A, and the positioning pin 33 when the fan main body 5 is housed in the housing recess 30 in an inverted state. That is, in the state where the fan main body 5 is inverted and the fan main body 5 is moved downward to bring the second holding lower surface 59b into contact with the claw upper surface 42b, the distance between the lower end of the positioning hole 57A and the housing bottom 31 is smaller than the height of the positioning pin 33.

The plurality of ribs 35 project radially outward in the radial direction of the axis O1 from the cylindrical portion 34b of the pin main body 34. Also, the ribs 35 extend along the axis O1. In the present embodiment, the rib 35 has a prismatic shape elongated in the vertical direction. The rib 35 extends upward along the outer peripheral surface of the cylindrical portion 34b from the bottom surface of the recess 33h. The plurality of ribs 35 are equally spaced along the axis O1. In the present embodiment, four ribs 35 are provided at intervals of 90° around the axis O1 with respect to one pin main body 34.

When the positioning pin 33 is inserted into the positioning hole 57, the plurality of ribs 35 contact the inner circumferential surface of the positioning hole 57. Therefore, the positioning pin 33 can be press-fit into the positioning hole 57 by elastically deforming the ribs 35 inward in the radial direction. Thus, the position of the positioning pin 33 can be suppressed from being shifted with respect to the positioning hole 57. Therefore, the fan main body 5 can be fixed in the housing recess 30 with high positional accuracy without being displaced. Further, as shown in FIG. 7, in the rib 35 of the present embodiment, the protruding height of the upper end portion decreases from the lower side toward the upper side. Thereby, the easiness in press-fitting the positioning pin 33 into the positioning hole 57 is enhanced.

When the positioning pin 33 is pressed into the positioning hole 57, part of the rib 35 that elastically deforms may be scraped off. According to the present embodiment, since the recess 33h is provided, part of the scraped rib 35 falls into the recess 33h. Therefore, the scraped rib 35 is not pinched between the lower surface 55d of the frame 55 of the fan main body 5 and the bottom surface 31a of the housing recess 30, so that the fan main body 5 can be suppressed from rising from the bottom surface 31a.

The present invention is not limited to the above-described embodiment, and other configurations can be adopted. For example, the number of fan main bodies 5 attached to the casing 2 is not limited to that described in the embodiment. Moreover, the number of snap-fit portions 4 with respect to one housing recess 30 is not limited to that described in the embodiment. Further, in the case of having a plurality of snap-fit portions, the claw lower surface 42a of at least one snap-fit portion 4 may be inclined. Further, the shape of the claw upper surface 42b is not limited to that described in the embodiment. Moreover, although the case where the claw portion 42 hooks on the upper holding portion 56 has been illustrated in the embodiment, it is also possible to employ a structure that it hooks on the upper surface 55c of the frame 55. Further, the above-described embodiment employs the configuration in which the lower holding portion 59 is provided to the frame 55 so that the fan main body 5 can be attached to the casing 2 even when the fan main body 5 is inverted. However, it is possible to adopt a structure in which the lower holding portion 59 is not provided, and the fan main body 5 may not be attached to the casing 2 when it is inverted. In that case, it can suppress the case where the fan main body 5 is assembled while being inverted.

The respective configurations can be appropriately combined within a range not inconsistent with each other.

### REFERENCE SIGNS LIST

- 1: fan unit
- 2: casing
- 3: main body
- 4, 4A, 4B: snap-fit portion
- 5: fan main body
- 30: housing recess
- 31: housing bottom
- 31a: bottom surface (surface facing upward)
- 31h: opening
- 32: housing inner circumferential portion
- 33: positioning pin
- 34: pin main body
- 34a: tapered portion
- 35: rib
- 41: elastic portion
- 42: claw portion
- 42a: claw lower surface (lower surface)
- 42b: claw upper surface (upper surface)
- 42t: tip
- 50: impeller (blade part)
- 55: frame
- 56: upper holding portion (holding portion, first holding portion)
- 56a, 59a: holding upper surface (upper surface)
- 56b, 59b: holding lower surface (lower surface)
- 57, 57A: positioning hole
- 59: lower holding portion (holding portion, second holding portion)
- d: height
- D3: distance

## Claims

1. A fan unit comprising:
a fan main body including a blade part that rotates, and a frame that rotatably supports the blade part; and
a casing including a main body provided with a housing recess in which the fan main body is to be housed, and a snap-fit portion for fixing the frame in the housing recess, wherein
the housing recess includes a housing bottom having a surface facing upward and a housing inner circumferential portion extending upward from the housing bottom, and opens upward,
the snap-fit portion includes an elastic portion extending upward along the housing inner circumferential portion, and a claw portion projecting horizontally from a tip end portion of the elastic portion,
a lower surface of the claw portion is inclined upward toward a tip of the claw portion, and
the frame is interposed between the lower surface of the claw portion and the housing bottom in a state of being in contact with the lower surface of the claw portion and the housing bottom.

2. The fan unit according to claim 1, wherein the casing includes at least a pair of the snap-fit portions, and the claw portions of the pair of the snap-fit portions face each other.

3. The fan unit according to claim 1 or 2, wherein an upper surface of the claw portion is inclined downward while increasing inclination with respect to a projecting direction of the claw portion toward the tip of the claw portion.

4. The fan unit according to any of claims 1 to 3, wherein the main body includes a positioning pin extending upward from the housing bottom, and the frame has a positioning hole into which the positioning pin is inserted.

5. The fan unit according to claim 4, wherein the positioning pin includes a tapered portion in which a diameter of the positioning pin decreases from a base end side toward a tip.

6. The fan unit according to claim 5, wherein
the fan main body includes a holding portion having an upper surface on which the lower surface of the claw portion contacts and hooks,
a lower surface of the holding portion contacts the upper surface of the claw portion when the fan main body is housed in the housing recess, and
in a state where the lower surface of the holding portion is in contact with the upper surface of the claw portion, a distance between a lower end of the positioning hole and the housing bottom is smaller than a height of the positioning pin.

7. The fan unit according to any one of claims 4 to 6, wherein the positioning pin includes a pin main body extending in a vertical direction, and a plurality of ribs projecting from an outer peripheral surface of the pin main body and extending in the vertical direction.

8. The fan unit according to any one of claims 1 to 3, wherein the fan main body includes a first holding portion and a second holding portion which are disposed at different positions in a vertical direction and overlap with each other when viewed in the vertical direction, and the claw portion hooks on the first holding portion and the second holding portion respectively when the fan main body is inverted.

9. The fan unit according to claim 8, wherein the main body includes a positioning pin extending upward from the housing bottom, and each of an upper surface and a lower surface of the frame has a positioning hole into which the positioning pin is inserted when the fan main body is inverted.

10. The fan unit according to claim 9, wherein the positioning pin has a tapered portion in which a diameter of the positioning pin decreases from a base end side toward a tip.

11. The fan unit according to claim 10, wherein a lower surface of one of the first holding portion and the second holding portion contacts the upper surface of the claw portion when the fan main body is housed in the housing recess, and in a state where the lower surface is in contact with the upper surface of the claw portion, a distance between a lower end of the positioning hole and the housing bottom is smaller than a height of the positioning pin.

12. The fan unit according to any one of claims 9 to 11, wherein the positioning pin includes a pin main body extending in a vertical direction, and a plurality of ribs projecting from an outer peripheral surface of the pin main body and extending in the vertical direction.
